Europäisches Patentamt

European Patent Office

Office européen des brevets

(11) Publication number: **0 200 332**
**A2**

# EUROPEAN PATENT APPLICATION

(21) Application number: 86302039.2

(22) Date of filing: 19.03.86

(51) Int. Cl.⁴: **C23C 16/54**

(30) Priority: 01.04.85 US 718571

(43) Date of publication of application:
**10.12.86 Bulletin 86/45**

(84) Designated Contracting States:
**CH DE FR GB IT LI NL**

(71) Applicant: **SOVONICS SOLAR SYSTEMS**
**6180 Cochran Road**
**Solon Ohio 44139(US)**

(72) Inventor: **Ovshinsky, Herbert**
**15200 Leslie**
**Oak Park Michigan 48237(US)**

(74) Representative: **Jackson, Peter Arthur et al**
**GILL JENNINGS & EVERY 53-64 Chancery**
**Lane**
**London WC2A 1HN(GB)**

(54) **Vertical apparatus for continuous deposition of semiconductor alloys.**

(57) Apparatus (26) for continuous deposition of semiconductor alloys by glow discharge including a plurality (28, 30, 32) of interconnected deposition chambers. At least one deposition chamber contains a generally vertical cathode plate (62) having opposed faces for establishing a plasma with a continuous substrate continuously passing through the chamber to deposit semiconductor alloy material on to the substrate. The apparatus includes rollers (76) about which the substrate is trained to advance the substrate between chambers in a generally horizontal path and through the chambers in a generally vertical path, opposed to the cathode plate, to shorten the apparatus.

EP 0 200 332 A2

**FIG. 2**

PAYOFF CHAMBER — CLEANING CHAMBER — $N_1$ CHAMBER

**FIG. 2 cont.**

$I_1$ CHAMBER — $P_1$ CHAMBER — INTERMEDIATE WEB CONTROL

$N_2$ CHAMBER — $I_2$ CHAMBER — $P_2$ CHAMBER

$N_3$ CHAMBER — $I_3$ CHAMBER — $P_3$ CHAMBER — TAKEUP CHAMBER

## VERTICAL APPARATUS FOR CONTINUOUS DEPOSITOIN OF SEMICONDUCTOR ALLOYS

Amorphous thin film semiconductor alloys have gained acceptance for the fabrication of electronic devices such as photovoltaic cells, photoresponsive and photoconductive devices, transistors, diodes, integrated circuits, memory arrays and the like. Amorphous thin film semiconductor alloys can be manufactured by relatively low cost continuous processes, possess a wide range of controllable electrical, optical and structural properties and can be deposited to cover relatively large areas. Among the semiconductor alloy materials exhibiting the greatest present commercial significance are amorphous silicon, germanium and silicon-germanium based alloys.

Commercial processes for the continuous roll-to-roll manufacture of large-area photovoltaic devices are disclosed in U.S. Patents 4,400,409, for A Method of Making P-Doped Silicon Films and Devices Made Therefrom, 4,410,588, for Continuous Amorphous Solar Cell Production Systems and 4,438,723, for Multiple Chamber Deposition and Isolation System and Method. As disclosed in these patents, a web of substrate material may be continuously advanced through a succession of interconnected deposition chambers, in each of which a specific layer of a semiconductor alloy is deposited on the web or on a previously deposited layer. In making a photovoltaic device, for instance, of n-i-p type configuration, the first chamber is dedicated to the deposition of a layer of an n-type semiconductor alloy material, the second chamber is dedicated to the deposition of a layer of an intrinsic amorphous semiconductor alloy, and the third chamber is dedicated to the deposition of a layer, of a p-type semiconductor alloy. The layers of semiconductor alloy thus deposited may be utilized to form photovoltaic devices that include one or more cascaded n-i-p cells. By making multiple passes through the succession of deposition chambers or by providing an additional array of deposition chambers, multiple cells of various configurations may be produced. The term "n-i-p type" refers to any sequence of n and p or n, i and p semiconductor alloy layers.

In devices currently manufactured, the thicknesses of individual layers of semiconductor alloy material vary from approximately 10 nanometers for the doped layers to approximately 350 nanometers for the thickest intrinsic layer. Since for a particular deposition process the speed of the web is fixed, the thickness of a deposited layer is directly related to the residence time of the web of substrate material in a deposition chamber. The thickest layer requires a deposition chamber 35 times longer than the thinnest layer. As more cells are deposited in one pass of a web substrate, the number of deposition chambers and the deposition apparatus becomes unmanageably long. In order to maintain a reasonably sized deposition apparatus, a machine design different from that disclosed in the cited patents is needed.

A non-horizontally disposed cathode plate for depositing semiconductor alloy material is described in U.S. Patent 4,423,701 for Glow Discharge Deposition Apparatus Including A Non-Horizontally Disposed Cathode. The vertical cathode disclosed there reduced the probability that deposition debris would fall on the vertically disposed substrate, requiring less down time for cleaning. The patent also disclosed the simultaneous use of two substrate webs, in two discrete plasma regions, one on each of the of the opposed faces of the vertical cathode. However, the patent did not consider or solve the problem of shortening an excessively long deposition apparatus for fabricating nine or twelve layer devices or improvements in efficiency of reaction gas useage.

In the invention, apparatus for the continuous vapor deposition of layers of semiconductor alloy material on a web substrate is disposed in a different orientation from that when the substrate travels between the chambers. Preferably the substrate is generally vertical during the deposition process and generally horizontal during transport between chambers resulting in a shortened apparatus. The web substrate is trained about a plurality of rollers that direct the web through and between the chambers.

A cathode plate disposed between oppositely moving generally vertical web portions deposits on two web surfaces simultaneously. The cathode is perforated so that a precursor gas mixture is uniformly distributed on both sides of the cathode. Ceramic magnets in the deposition chambers urge the magnetic substrate web generally into a plane in the regions where deposition occurs.

In a preferred embodiment, at least one group of three deposition chambers are included in the apparatus, one of which is dedicated to the deposition of an n-type semiconductor alloy, another of which is dedicated to the deposition of a p-type layer, while the middle chamber is dedicated to the deposition of an intrinsic type layer. Additional groups of three deposition chambers may be added for depositing additional n-i-p cells.

The generally vertical cathodes are housed in a series of cathode towers. The height of each of the cathode towers and the number of cathode towers may be selected to produce a desired concentration profile of constituents in the deposited semiconductor alloy. An insulating film may be applied to one face of a cathode plate in one or more of the cathode towers to limit the length of the plasma region of the tower.

Figure 1 is a fragmentary, cross-sectional view of a photovoltaic device including a plurality of p-i-n type cells.

Figure 2 is a schematic depiction of a continuous deposition apparatus according to the invention.

Figure 3 is a cross-sectional view of one of the deposition chambers of Figure 2.

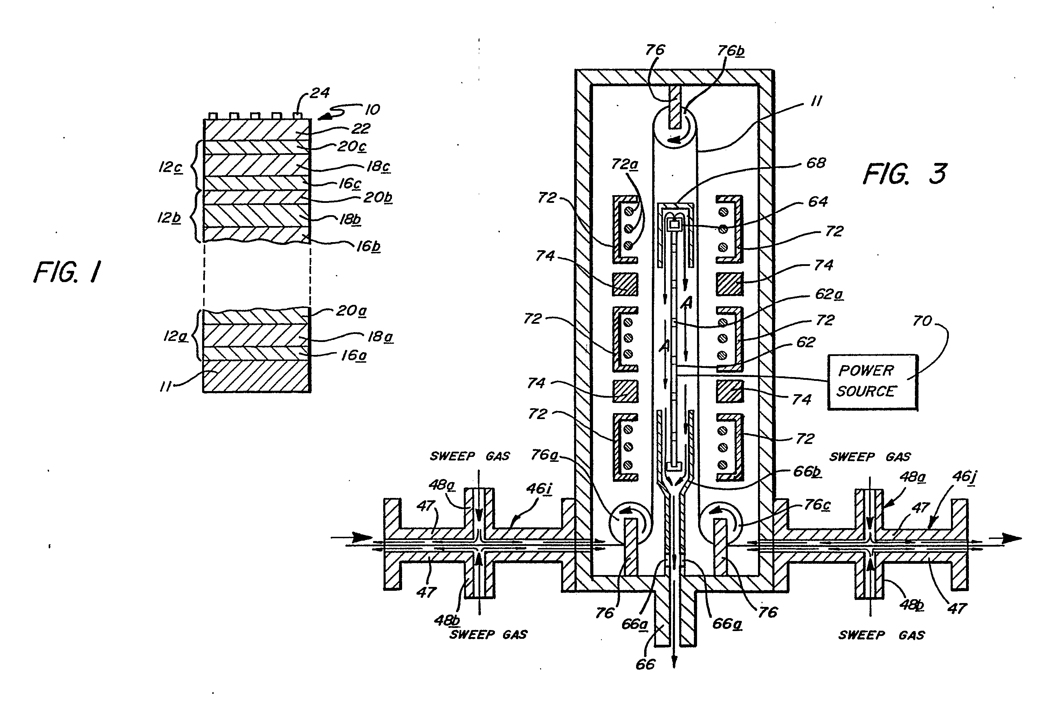

In Figure 1, a p-i-n type photovoltaic device 10, such as a solar cell, is made up of individual p-i-n type cells 12a, 12b and 12c. Below the lowermost cell 12a is a substrate 11 which may be transparent, formed from a metallic material such as stainless steel, aluminum, tantalum, molybdenum, chrome, or metallic particles embedded within an insulator, or formed of synthetic polymers, glass or a glass-like material on which an electrically conductive electrode has been applied.

Each of the cells 12a, 12b and 12c are preferably fabricated with a thin film semiconductor body containing at ·least a silicon alloy. Each of the semiconductor bodies includes a p-type conductivity semiconductor layer 20a, and 20b and 20c; a substantially intrinsic semiconductor layer 18a,18b and 18c; and an n-type conductivity semiconductor layer 16a,16b and 16c. As illustrated, cell 12b is an intermediate cell and additional intermediate cells may be stacked on the illustrated cells or the device may include only two cells. A TCO - (transparent conductive oxide) layer 22, preferably formed of indium tin oxide, is deposited on layer 20c. An electrically conducting grid 24 may be deposited on layer 22 to increase the current collection efficiency.

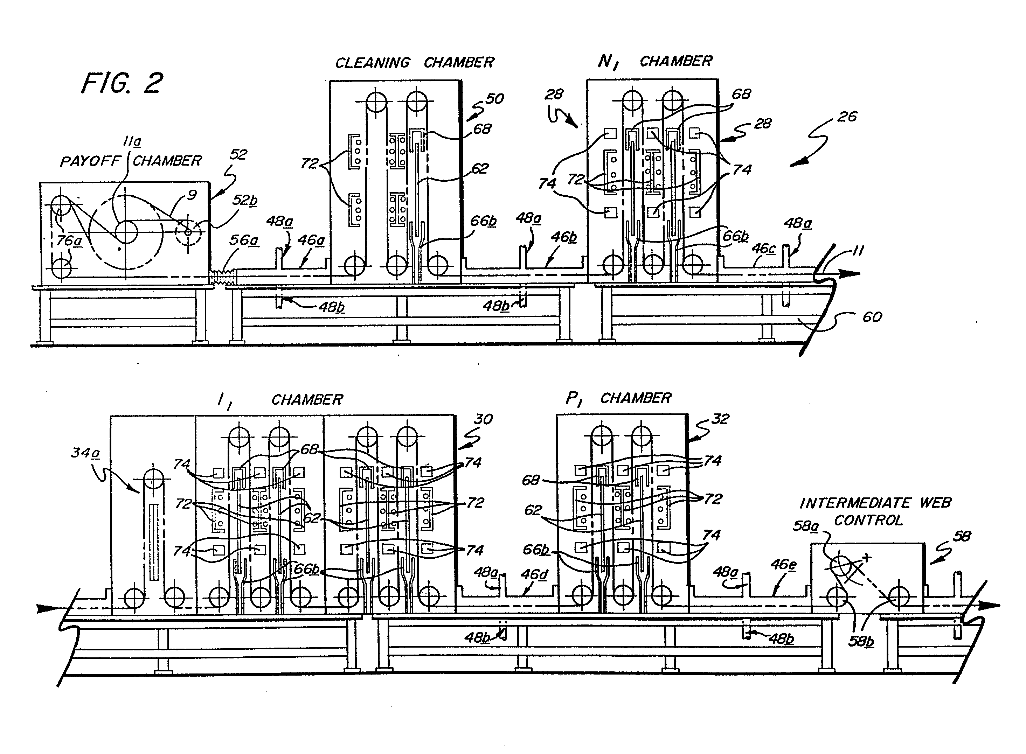

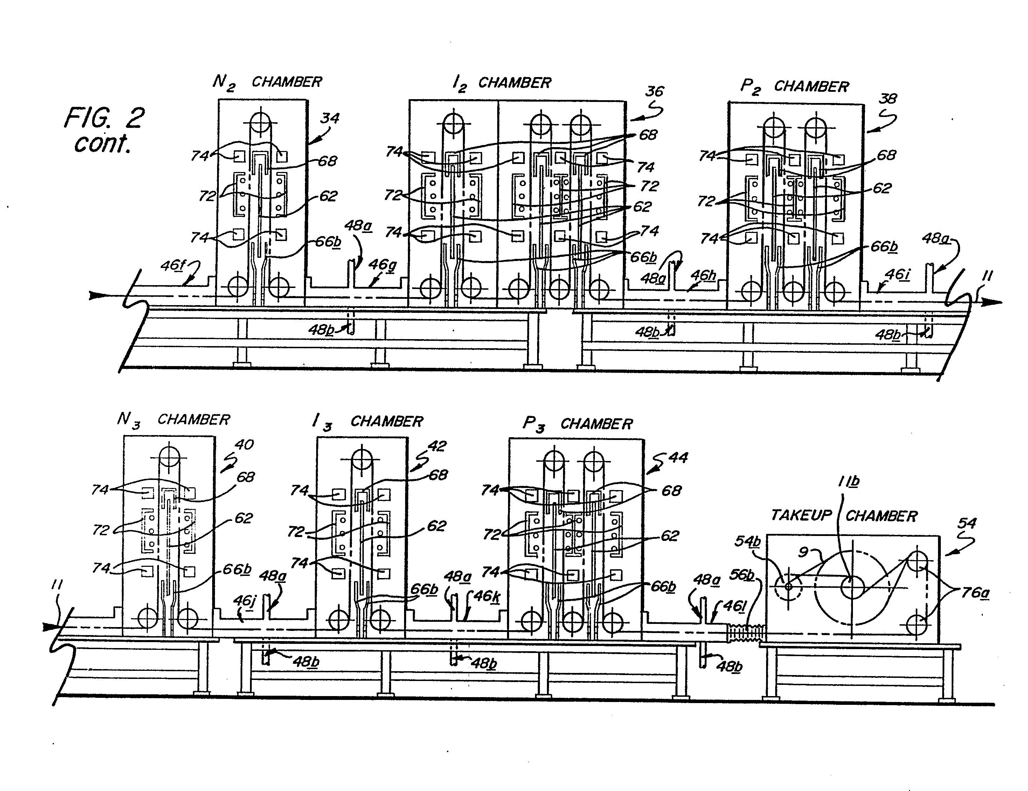

Figure 2 shows a diagrammatic representation of an embodiment of a deposition apparatus 26 according to the invention. Figure 2 appears in four sections because of the length of apparatus 26. The sections fit together end to end as explained in the following description. Apparatus 26 includes a plurality of deposition chambers through which a continuous web substrate 11 passes. The chambers are aligned so that the path of the substrate consists of generally vertical and generally horizontal portions with no significant or intentional side-to-side movement. A particular gaseous mixture of process gases is introduced into each chamber for depositing ‘a particular type of semiconductor alloy in that chamber. The atmospheres in separate chambers are mutually isolated by isolation modules disposed between adjacent chambers.

Apparatus 26 is configured to manufacture a structure having three n-i-p type cells in a large volume over large areas. Apparatus 26 includes a first deposition chamber 28 for depositing an n-type conductivity layer of semiconductor alloy on web substrate 11 as the web continuously moves through chamber 28. After leaving chamber 28, the coated web enters deposition chamber 30 in which a layer of substantially intrinsic semiconductor alloy is deposited on the n-type layer. To complete the first cell, the coated web exits chamber 30 and enters a chamber 32 in which a layer of p-type conductivity semiconductor alloy is deposited on the intrinsic layer. The additional two cells are deposited in the same fashion in the six following deposition chambers. In a fourth deposition chamber 34, a second n-type conductivity layer is deposited; in a fifth deposition chamber 36, a second layer of intrinsic amorphous semiconductor alloy is deposited; in a sixth deposition chamber, a second layer of p-type conductivity semiconductor alloy is deposited; in a seventh deposition chamber 40, a third layer of n-type conductivity semiconductor alloy is deposited; in an eighth deposition chamber 42, a third layer of intrinsic semiconductor alloy is deposited; and in a ninth deposition chamber 44, a third layer of p-type conductivity semiconductor alloy is deposited, to complete the nine layer deposition sequence possible in apparatus 26 with a single passage of substrate 11 through it. Additional individual or groups of three deposition chambers may be added to change the capabilities of apparatus· 26. The sequence in which the conductivity types of the layers is deposited may be reversed or otherwise altered. Discrete substrates may also be continuously fed through the apparatus.

Since a continuous substrate passes through each chamber at the same speed, the thickness of a layer deposited in a particular chamber is directly related to the amount of time a particular point on the substrate is resident within that chamber. To deposit layers of different thicknesses, the geometry of the chambers must be varied to change residence time. Such a change can be seen by comparing chambers 28 and 30. Since the first intrinsic layer is preferably the thickest layer, the path of travel of web 11 through chamber 30 is much longer than the path of travel through chamber 28. Chamber 28 contains a total of five rollers over which web 11 is trained and four deposition regions, as further explained below. By contrast, chamber 30 contains eight deposition regions with a total of ten rollers for guiding web 11. As a result, a far thicker layer may be deposited in chamber 30 than can be deposited in chamber 28.

Apparatus 26 includes a plurality of isolation modules 46a-46l that mutually isolate the gaseous mixtures in a particular deposition chamber from the mixtures in adjacent chambers. The isolation modules 46a-46 lare disposed externally and between adjacent deposition chambers and interconnect the chambers for a passage of substrate 11 through the apparatus. External isolation modules of this type are disclosed in U.S. Patent 4,480,585. Generally, the isolation modules 46a -46l are defined by a pair of elongated, horizontally-disposed, passageway-forming plates 47 (see Figure 3). Web 11 passing through the passageway defines an upper and lower channel through which a sweeping gas, such as hydrogen or argon, flows to prevent the diffusion of gas mixtures between adjacent deposition chambers. Each of the isolation modules 46a-46l includes opposed gas introductory conduits 48a and 48b through which sweeping gas is introduced into the channels. The sweeping gas flows into the adjacent chambers and prevents the diffusion of precursor gaseous mixtures between the adjacent chambers.

A substrate cleaning chamber 50 is disposed between a chamber 52, from which substrate 11 is paid out from a supply roll 11a, and first deposition chamber 28. Web 11 is subjected in chamber 50 to a high temperature, about 450 degrees Celsius, to bake out contaminants. A plasma may also be established in chamber 50 between a cathode and the substrate to remove contaminants.

Preferably, the surface web 11 is protected by a sheet of material, such as paper, that is disposed between the wound layers of the roll of substrate web. As web 11 is unwound from roll 11a, protective interleaf sheeting 9 is collected on an interleaf take-up roller 52b. A pair of idler turning rollers 76a in chamber 52 direct web 11 in a generally horizontal path toward chamber 50.

At the other end of apparatus 26, following the path of web 11 out of chamber 44, the coated web is collected in a take-up chamber 54 and wound about a take-up roll 11b. As web 11 is being wound, a sheet of protective interleaf sheeting 9 from an interleaf pay-off roller 54b is inserted in the coil and wound with the web. Coated web 11 is trained over a pair of idler turning rollers 76 in chamber 54 toward take-up roller 11b

External isolation modules 46a and 46linclude bellows sections 56a and 56b, respectively, connected to the pay-off and take-up chambers, respectively to accommodate any expansion or contraction that may occur during operation of the apparatus. An intermediate web controller chamber 58, is disposed between deposition chambers 32 and 34 to maintain proper tension on web 11. Within controller chamber 58, spring tensioning roller 58a cooperates with a pair of turning rollers 58b to tension web 11. Additional controller chambers may be added along the path of travel of web 11.

In Figure 3 the interior structure of a deposition chamber is shown schematically. From that drawing and the following description, the structure of all the deposition chambers of apparatus 26 may be understood. The deposition chamber of Figure 3 is generally vertical. That is, web 11 enters in a generally horizontal plane, then is turned to a generally vertical plane for deposition and back to a generally horizontal plane to exit the chamber. Because of this orientation, there is a distinct top and bottom orientation in the chamber. The chamber contains a generally vertical cathode plate 62 containing a plurality of apertures for the uniform mixing of process gases introduced from an apertured manifold 64. An upper, inverted U-shaped cathode shield 68 restricts the precursor gaseous mixture from exiting the plasma region between the cathode and substrate. A lower cathode shield 66b, opposite shield 68, prevents spent gases from leaving the cathode region. Cathode shield 66b includes a conically-shaped portion, tapering downward, that is operatively connected to an exhaust conduit 66 for exhausting spent gases. Cathode shield 66b includes a plurality of apertures 66a on both sides for exhausting sweeping gases introduced from the isolation modules 46. Both upper cathode shield 68 and lower cathode shield 66 b are elongated members that extend across the full transverse extent of the deposition chamber are coextensive with the transverse extent of web 11 and cathode plate 62, to confine the gaseous precursor mixture to the plasma regions between the cathode plate and web.

The precursor gaseous mixture flows generally parallel to web 11. Banks of substrate heaters 72a, including heat reflecting shields 72, are disposed on both sides of web 11 to maintain its temperature at a preselected value. A plurality of elongated ceramic magnets 74 are disposed along the path of travel of web 11 to urge a magnetic web into a plane in the plasma region. A power source 70, for example a source of radio frequency energy, supplies power to cathode plate 62 to establish and maintain a plasma betwen the cathode and an electrically conductive grounded web 11. The plasma is formed on both sides of cathode plate 62. Web 11 is coated in each plasma as it passes through the chamber.

Web 11 is turned from its generally horizontal path on entering the chamber by a first turning roller 76a that is rotatably mounted on a support 76. After passing about roller 76a, web 11 assumes a generally vertical orientation and moves upward past the plasma region created on one side of cathode plate 62. Web 11 then is trained over a second turning roller 76b, disposed near the top of the chamber and rotatably mounted on another support 76. Roller 76b changes the direction of movement of the web material 11 from upward to downward, while maintaining the generally vertical orientation. The web passes through the other plasma region on the opposite face of cathode 62 and receives a second coating. Finally, a third turning roller 76c, that is rotatably mounted on yet another support 76, changes the direction of travel of the web to a generally horizontal orientation out of the chamber and into external isolation module 46j. Since roller 76b may be in surface-to-surface contact with the coated surface of the web, the central portion of said roller 76b is preferably recessed so that only the edges of the web contact roller 76b. The contact area is reduced to avoid scratching or other damage from frictional contact between the web and roller.

The number of vertically oriented cathode plates 62 disposed in a single deposition chamber and the heights of those plates is essentially unlimited. A thicker layer of semiconductor alloy may be deposited on a web substrate by increasing the number of such cathode plates in a chamber without a significant increase in the length of the apparatus. A single source of the precursor gaseous mixture is introduced into the cathode region for simultaneous decomposition on both faces of the cathode plate, thereby using a greater percentage of the gas introduced into the chamber.

The novel apparatus may also be used to "profile" a depositing a layer of semiconductor alloy. Profiling means the incorporation of a reduced or increased percentage of one component of a gaseous precursor through a given thickness of a layer of semiconductor alloy material. For instance, an intrinsic layer is routinely profiled with an increasing amount of boron from the light incident surface to the bottom of the layer to achieve uniform absorption of photons throughout the bulk of that intrinsic layer. Since the precursor gaseous mixture introduced into each of the vertically disposed cathode towers may be individually selected, and the height of each of the vertically disposed cathodes, and hence the length of time the web of substrate material resides within the plasma regions, may be separately selected for each chamber, profiling is readily accomplished. In addition one face of a cathode plate 62 can be insulated so that a plasma region forms only adjacent the noninsulated face. For example, in deposition chamber 30, cathode tower 34a is shorter than the remaining cathode towers. The left hand face of the cathode in tower 34a is coated with an electrically insulating polyimide film, so that only one plasma region is formed in the tower. Therefore, of the intrinsic layer deposited in chamber 30, the portion deposited in tower 34a may have a different composition from remainder of the layer.

**Claims**

1. Apparatus (26) for continuous deposition of semiconductor alloy material, said apparatus including:

a plurality of descrete deposition chambers (28, 30, 32, 34, 36, 38, 40, 42, 44) in each of which a layer of semiconductor may be deposited;

means (11 a, 11b) for continuously advancing a continuous web substrate through said chambers, each chamber containing a manifold (64) for introducing a mixture of precursor into the chamber, an exhaust conduit (66) for exhausting spent gases from the chamber, and at least for one cathode for establishing a glow discharge with said substrate for decomposing the precursor mixture in a plasma region;

isolation modules (46) interconnecting adjacent ones of said chambers for passage of the substrate and isolating the precursor gas mixtures in adjacent chambers from each other, characterized in that

at least one of said chambers includes means (76) for directing said substrate in a generally vertical orientation through said plasma region and the cathode contained within said chamber is generally vertically oriented.

2. The apparatus of claim 1 characterized in that said means for direction said substrate includes a plurality of rollers (76a, 76b, 76c) about which said substrate is trained.

3. The apparatus of claims 1 or 2 characterized in that said means for continuously advancing a substrate includes a plurality of rollers (76a, 76c) for advancing said substrate between adjacent deposition chambers in a generally horizontal orientation.

4. The apparatus of any one of claims 1, 2 or 3 wherein said vertically oriented cathode has opposed generally vertically oriented faces for establishing a plasma region opposite each said face.

5. The apparatus of claim 4 characterized in that at least a portion of one face of the cathode plate is coated with an insulating film to prevent establishment of a plasma region opposite said insulated face.

6. The apparatus of any preceding claim wherein at least one of said rollers (76b) is recessed to contact only the edges of said substrate.

7. The apparatus of any one of the preceding claims wherein at least one deposition chamber -

(30) includes at least one deposition region (34a) distinct from other deposition regions within the chamber.

8. The apparatus of claim 7 wherein the length of the path of travel the substrate through said distinct deposition region (34a) differs from another deposition region in said chamber (30) in the length of the path of travel of the web.

9. The apparatus according to any one of the preceding claims including a cleaning chamber for cleaning the substrate before it enters the deposition chambers, said cleaning chamber including means for directing said substrate in a generally vertical orientation through said cleaning chamber.

10. The apparatus according to any one of the preceding claims including at least one bellows through which said substrate passes for accommodating expansion and contraction of the apparatus.

FIG. 1

FIG. 3

POWER SOURCE

SWEEP GAS

SWEEP GAS

SWEEP GAS

SWEEP GAS

0 200 332

# FIG. 2

CLEANING CHAMBER

$N_1$ CHAMBER

PAYOFF CHAMBER

11a

52

9

52b

76a

56a

48a

46a

50

68

72

62

66b

48a

46b

48b

28

28

74

72

66b

46c

48a

11

60

26

74

$I_1$ CHAMBER

$P_1$ CHAMBER

34a

74

68

74

72

62

74

66b

30

74

72

68

62

66b

74

48a

46d

48b

48a

INTERMEDIATE WEB CONTROL

58a

58

46e

58b

48b

32

0 200 332

FIG. 2
cont.

0 200 332